# EUROPEAN PATENT APPLICATION

(11) **EP 2 779 218 A2**
(43) Date of publication of application: **17.09.2014**
(21) Application number: 14159646.0
(22) Date of filing: 13.03.2014
(51) Int. Cl.: H01L 21/336, H01L 29/778, H01L 29/06

(54) **Method of forming hemt semiconductor devices and structure therefor**

(30) Priority: 15.03.2013 US 201361798930 P; 23.01.2014 US 201414162082
(71) Applicant: Semiconductor Components Industries, LLC, Phoenix, AZ 85008 (US)
(72) Inventor: Parsey, Jr, John, Phoenix, AZ Arizona 85048 (US); Liu, Chun Li, Scottsdale, AZ Arizona 85259 (US); Padmanabhan, Balaji, Tempe, AZ Arizona 85281 (US)
(74) Representative: Clarke, Geoffrey Howard

(57) **Abstract**

In one embodiment, a HEMT semiconductor device includes an isolation region that may include oxygen wherein the isolation region may extend thorough an ALGaN and GaN layer into an underlying layer.

## Description

The present invention relates, in general, to electronics, and more particularly, to semiconductors, structures thereof, and methods of forming semiconductor devices.

In the past, the semiconductor industry utilized various different device structures and methods to form high electron mobility (HEMT) semiconductor devices. Some of the devices used gallium nitride (GaN) as one of the semiconductor materials to achieve the high mobility. GaN and other HEMT devices incorporate a two-dimensional electron gas (2DEG) generated by strain and polarization charge transfer at the AlGaN/GaN interfacial region in the GaN layer.

One problem with these prior structures and devices was that the materials used for insulators and/or dielectrics generally did not have a high enough dielectric constant (k) or often resulted in forming stresses in the resulting devices.

It is an objective of the present invention to overcome at least some of the problems and disadvantages of the prior art.

Accordingly, it is desirable to have a HEMT semiconductor device and method therefor that includes high dielectric constant insulator and/or dielectric materials and that reduces stresses in the devices.

According to one aspect of the present invention there is provided a HEMT semiconductor device comprising: a semiconductor substrate having a surface; a GaN layer overlying the surface of the semiconductor substrate; an AlGaN layer proximal to the GaN layer in which a proximity of the GaN and AlGaN layers and a mole fraction of materials in the AlGaN layer is configured to form a 2DEG in the GaN layer; a dielectric layer overlying the AlGaN layer; and an isolation region extending from a surface of the AlGaN layer through a first portion of the dielectric layer, through the AlGaN layer, and into a first portion of the GaN layer, the isolation region forming a multiply connected domain encircling second portions of the dielectric, GaN, and AlGaN layers in which the isolation region is formed from one of forming oxygen atoms in the first portions of the AlGaN and GaN layers, forming acceptor atoms in the first portions of the AlGaN and GaN layers, or damaging atoms in the first portions of the AlGaN and GaN layers.

According to another aspect of the present invention there is provided a method of forming a HEMT semiconductor device which comprises: providing a substrate; forming a plurality of III-V or II-VI compound semiconductor layers overlying the substrate in which a material within at least a first semiconductor layer of the plurality of compound semiconductor layers is configured to form a 2DEG; and forming an isolation region extending through a first portion of the plurality of compound semiconductor layers and at least to the 2DEG.

The invention will now be described with reference to the accompanying figures in which:
FIG. 1 illustrates an enlarged plan view of an example of a portion of an embodiment of a HEMT semiconductor device in accordance with the present invention;
FIG. 2 illustrates an enlarged cross-sectional view of an example of a portion of an embodiment of a HEMT semiconductor device in accordance with the present invention; and
FIG. 3 illustrates an enlarged cross-sectional view of an example of a portion of an embodiment of a HEMT semiconductor device that is an alternate embodiment of the semiconductor device of FIG. 2 in accordance with the present invention.

For simplicity and clarity of the illustration(s), elements in the figures are not necessarily to scale, and the same reference numbers in different figures denote the same elements, unless stated otherwise. Additionally, descriptions and details of well-known steps and elements are omitted for simplicity of the description. As used herein current carrying electrode means an element of a device that carries current through the device such as a source or a drain of an MOS transistor or an emitter or a collector of a bipolar transistor or a cathode or anode of a diode, and a control electrode means an element of the device that controls current through the device such as a gate of an MOS transistor or a base of a bipolar transistor. Although the devices are explained herein as certain N-channel or P-Channel devices, or certain N-type or P-type doped regions, a person of ordinary skill in the art will appreciate that complementary devices are also possible in accordance with the present invention. One of ordinary skill in the art understands that the conductivity type refers to the mechanism through which conduction occurs such as through conduction of holes or electrons, therefore, and that conductivity type does not refer to the doping concentration but the doping type, such as P-type or N-type. It will be appreciated by those skilled in the art that the words during, while, and when as used herein relating to circuit operation are not exact terms that mean an action takes place instantly upon an initiating action but that there may be some small but reasonable delay(s), such as various propagation delays, between the reaction that is initiated by the initial action. Additionally, the term while means that a certain action occurs at least within some portion of a duration of the initiating action. The use of the word approximately or substantially means that a value of an element has a parameter that is expected to be close to a stated value or position. However, as is well known in the art there are always minor variances that prevent the values or positions from being exactly as stated. It is well established in the art that variances of up to at least ten per cent (10%) (and up to twenty per cent (20%) for semiconductor doping concentrations) are reasonable variances from the ideal goal of exactly as described. The terms first, second, third and the like in the claims or/and in the Detailed Description of the Drawings, as used in a portion of a name of an element are used for distinguishing between similar elements and not necessarily for describing a sequence, either temporally, spatially, in ranking or in any other manner. It is to be understood that the terms so used are interchangeable under appropriate circumstances and that the embodiments described herein are capable of operation in other sequences than described or illustrated herein. For clarity of the drawings, doped regions of device structures are illustrated as having generally straight line edges and precise angular corners. However, those skilled in the art understand that due to the diffusion and activation of dopants the edges of doped regions generally may not be straight lines and the corners may not be precise angles.

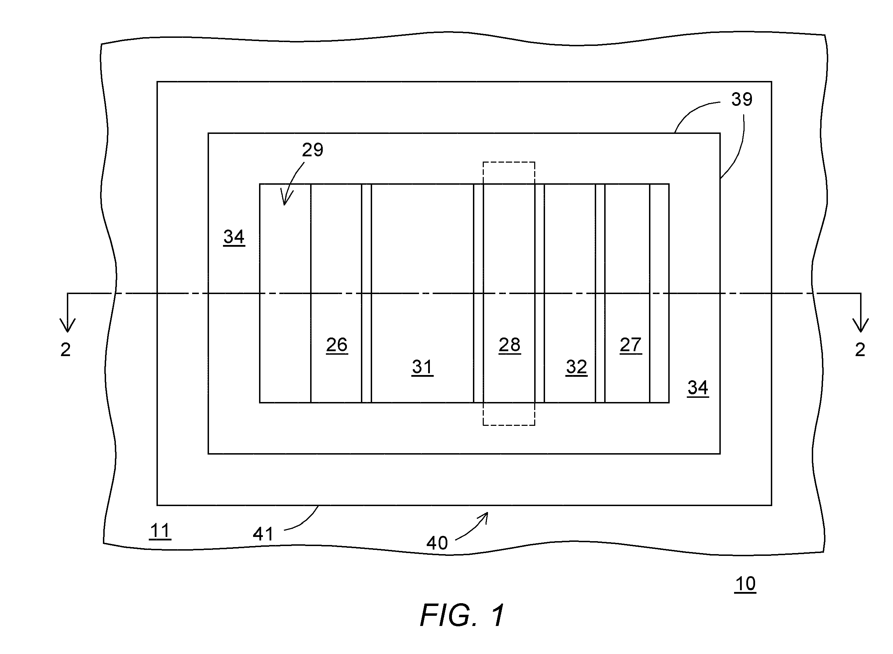

In addition, the description illustrates a cellular design (where the body regions are a plurality of cellular regions) instead of a single body design (where the body region is comprised of a single region formed in an elongated pattern, typically in a serpentine pattern). However, it is intended that the description is applicable to both a cellular implementation and a single base implementation.FIG. 1 illustrates an enlarged plan view of an example of a portion of an embodiment of a HEMT semiconductor device that has improved isolation. In one non-limiting example embodiment, the HEMT semiconductor device is a HEMT transistor 10 that has improved isolation that can sustain differential voltages applied between the electrodes of transistor 10 that are greater than approximately one hundred volts (100V). In some embodiments, transistor 10 can sustain voltages over six hundred volts (600V) and up to several thousand volts, such as up to three thousand volts (3000 V) in some embodiments. Transistor 10 includes an active area or active region 29, illustrated in a general manner by an arrow, and an inactive area external to area 29.

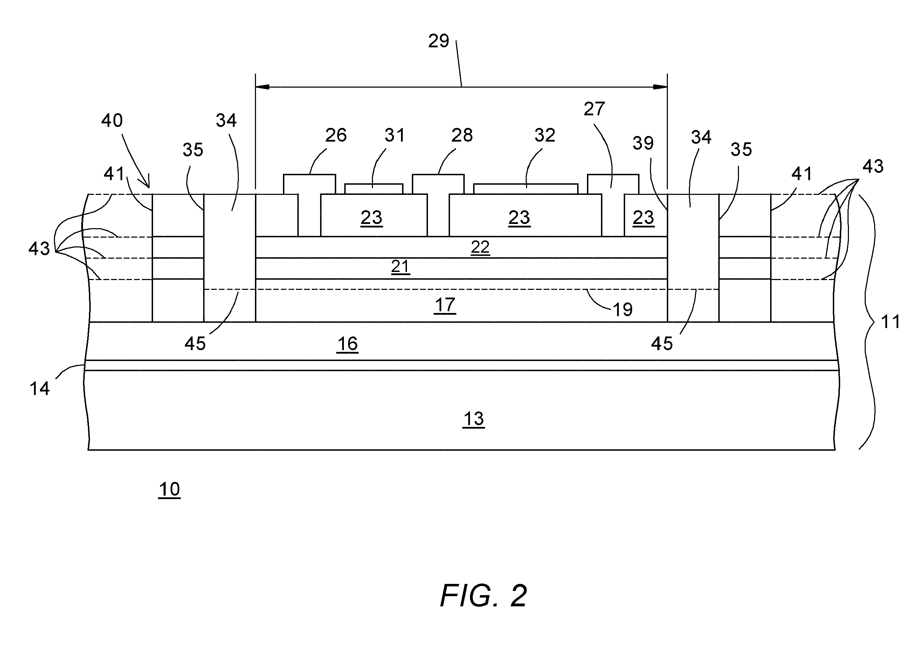

FIG. 2 illustrates an enlarged cross-sectional view of an example of a portion of an embodiment of transistor 10 along cross-section lines 2-2 of FIG. 1. This description has references to FIG. 1 and FIG. 2. Transistor 10 is formed on a semiconductor substrate 11. Substrate 11 typically includes a plurality of layers. In one embodiment, substrate 11 includes a bulk substrate 13 on which a plurality of semiconductor layers are formed overlying substrate 13. Substrate 13 may be one of many different bulk substrates including silicon, silicon-on-insulator (SOI), a compound semiconductor material such as any group III-V or II-VI materials, ceramic, metal, or various other substrate materials.

An embodiment may include forming an optional nucleation layer 14 on substrate 13. Nucleation layer 14 may include a layer of GaN, or AlGaN, or some combination thereof, or other suitable elements. A buffer layer 16 may be formed on layer 14 or on substrate 13 such as if layer 14 is omitted. Buffer layer 16 and layer 14 may be formed as epitaxial layers by known epitaxial formation techniques. In some embodiments, buffer layer 16 serves as a transition layer to reduce strain between the material of substrate 13 and overlying layers of transistor 10. In one example embodiment, buffer layer 16 may include a layer of AlGaN having an Al mole fraction that varies according to the distance from substrate 13, such as for example decreasing for increasing distance from substrate 13). Transistor 10 usually also includes a channel layer 17 overlying buffer layer 16 and a barrier layer 22 overlying channel layer 17. In one embodiment, layers 17 and 22 also may be formed as epitaxial layers. An embodiment includes forming barrier layer 22 as a layer of AlGaN and forming channel layer 17 as a layer of GaN. In the preferred embodiment, barrier layer 22 is formed on channel layer 17. An optional spacer layer 21 may be formed between channel layer 17 and barrier layer 22. An embodiment includes forming layer 21 as a layer of AlN. At least one insulator or dielectric layer 23 is formed on or overlying barrier layer 22 to insulate barrier layer 22 from conductors or electrodes used to form source, drain, and/or gate conductors or electrodes, and possibly from other electrical elements or devices external to transistor 10, such as other HEMT devices on substrate 11. Insulator layer 23 may include a plurality of insulator or dielectric layers and different insulator or dielectric materials, such as for example SiO_{X}, SiO_{X}N_{Y}, Si_{X}N_{Y}, Al_{X}O_{Y} HFO_{X}, ZRO_{X}, and/or others. In one embodiment, openings may be formed through insulator 23 to expose the surface of barrier layer 22 where the source, drain, and gate electrodes are to be formed. Thereafter, conductor material may be applied and patterned (or optionally mask patterned) to form a source electrode 26, a drain electrode 27, and a gate electrode 28 electrically and mechanically contacting layer 22. In another embodiment, different conductor materials may be used for the gate electrode than for the source and drain electrodes. In another embodiment, a gate insulator may be formed on layer 22 and underlying electrode 28 prior to forming electrode 28.

The material used to form layers 17 and 22 form a strain-induced quantum well near the interfacial region of layers 17 and 22 as illustrated in a general manner by a dashed line 19. The proximity of layers 17 and 22 assist in forming the quantum well to be substantially continuous from layer 17 to layer 22, in some embodiments the material of layer 21 assists in the continuity of the quantum well. The quantum well may be formed with an Al content of around five to thirty five percent (5%-35%) and may typically be in the range of approximately twenty percent (20%). The two-dimensional electron gas (2DEG), illustrated in a general manner by a dashed line 19, generally is formed in the area of the quantum well. Those skilled in the art will appreciate that although the described example embodiments include layers of GaN and AlGaN to form the 2DEG, other material may also be used such as other compound semiconductor materials including other III-V and II-VI compound materials, to assist in forming the 2DEG. The charges induced in the quantum well can cause current flow within the quantum well (such as near or within the region of dashed line 19).

An isolation region 34 is formed extending into the structure of transistor 10 in order to minimize leakage current, that may be formed by portions of the 2DEG, escaping along outer periphery 39 of active region 29. Without region 34, leakage currents could flow from active region 29 externally to transistor 10. Such leakage current could degrade the high voltage breakdown characteristics of transistor 10. Isolation region 34 preferably is formed to minimize exposure of any of the portion of the channel region within the structure formed by region 34 and where the 2DEG region is formed. This minimizes leakage of electrons that may be present around the perimeter of transistor 10, such as perimeter 39 for example. For example can we say - although transistor 10 is lustrated with layer 22 overlying layer 17 the positions may be changed as long as there is an interfacial region where layers 17 and 22 are proximal such that the band-gaps of the material are configured to form the 2DEG. For example layer 17 may be formed overlying layer 22. Extending gate electrode 28 so that distal edges at least overlie an edge of region 34 (FIG. 1) or even extend to overlie more of region 34 (such as illustrated by dashed lines) also may assist in reducing the leakage current.

Those skilled in the art will appreciate that isolation region 34 typically is formed as one substantially continuous structure having an opening in the center of the structure, such as for example a multiply-connected domain including for example a closed polygon, wherein the structure surrounds portions of transistor 10 so that most of the GaN and AlGaN are within the opening of the structure. Although region 34 is described as a substantially continuous structure, it is envisioned that small openings or spaces (such as a space that is less than approximately one or two percent [1-2%] of the total periphery) within the structure would still be regarded as substantially continuous. Region 34 could have various other shapes than the parallelogram shape illustrated n FIG. 1 including a circle or an irregular shape. In most embodiments, at least portions of a source and drain of transistor 10 are within the opening of the structure. In some embodiments, the substrate may function as the source of the transistor, thus, all of the source may not be internal to the opening of the structure. Those skilled in the art will also appreciate that other devices also may be formed within the multiply-connected domain including passive devices such as resistors and/or capacitors.

Isolation region 34 usually is formed prior to forming metal interconnect conductors, for example prior to forming electrodes 26-28, on layers of transistor 10 above dielectric layer 23. Isolation region 34 may also be formed prior to forming field plates, such as field plates 31-32 for example. Those skilled in the art will understand that one or all of plates 31-32 may include a plurality of layers such as alternating layers of conductors and insulators, and that device 10 may include more than two field plates.

Isolation region 34 may be formed to extend through an interfacial region of layers 22 and 17 where the 2DEG is formed. In one embodiment, region 34 is formed to extend from at least the surface of dielectric layer 23 through layer 22 and at least into layer 17 past the interfacial region where the 2DEG will be formed such as for example to a depth as illustrated by a dashed line 45. In some embodiments, region 34 may extend further into layer 17 and in some embodiments may extend to touch or alternately extend at least a distance into buffer layer 16. In one embodiment, portions of at least layers 17 and 22 extend outside of the multiply-connected structure formed by isolation region 34. In another embodiment, layers 17, 22, and 23 are formed. An embodiment may include forming regions 34 prior to removing portions of layers 23, 22, 21, or 17 that are external to active region 29.

Those skilled in the art will appreciate that although region 34 is illustrated to have substantially vertical sidewall(s), in other embodiments region 34 may have slanted sidewall(s) such that the width of active region 29 may decrease with increasing depth into transistor 10, or alternately may increasing with increasing depth. For example, region 34 may be formed by implanting atoms at an angle relative to the top surface of transistor 10.

In one embodiment, forming region 34 may include implanting oxygen ions at least into layer 22 and the top most portion of layer 17 surrounding or bounding active region 29. The oxygen atoms may be implanted in one implant operation or multiple implants in order to form the isolation regions at the desired depths. In one embodiment, the oxygen ions actively combine with the gallium and/or with the aluminum atoms in the GaN and/or AlGaN layers to form highly insulating oxides thereby forming high integrity isolation regions. In one non-limiting example embodiment, the oxygen ions combine to form oxides such as Ga₂O₃ and/or Al₂O₃ and/or sub-oxides thereof. These oxides minimize leakage of current in high field conditions and simplify the wafer processing and ESD performance. Isolation region 34 increases the breakdown voltage of transistor 10 and provides operation at differential voltages of at least one hundred volts (100V) between the gate-drain and/or gate-source electrodes of transistor 10. The oxygen atoms typically would also be implanted into and through layer 23. Those skilled in the art will appreciate that the oxygen atom may not change the characteristics of the material of layer 23 and that the portion of layer 23 where the oxygen atoms are implanted is a portion of region 34.

Isolation region 34 may be more effective at high voltages than other isolation regions such as those formed using nitrogen or such as a mechanical trench which may create other leakage paths, or require an additional passivation layer. Isolation region 34 has a higher dielectric constant than prior isolation structures and minimizes stresses in transistor 10.

In another embodiment, region 34 may be formed by implanting atoms of species that damage the material at least of layers 17 and 22 and form recombination sites within the material. The recombination sites may include atoms of layers 22 and 17 that are damaged and/or replaced and as a result have a dangling bond site which can accept an electron. For example, the damage may cause a Ga atom to have an unsatisfied bond which can accept a free electron. Such implant materials include implanting helium (He), hydrogen (H), iron (Fe), argon (Ar), nitrogen (N), carbon (C), magnesium (Mg), and other damage causing elements. The implant material may also include combinations of such elements such as for example, N+He, N+H, etc. Those skilled in the art will appreciate that the atoms of the species that damage the material of layers 17 and 22 typically are implanted through the portion of layer 23 that is within region 34. The portion of layer 23 that is within region 34 continues to function as an insulator or dielectric.

In another embodiment, forming region 34 may include forming atoms of elements that can function as acceptors at least in portions of layers 22 and 17. Such acceptor elements include atoms of elements that have a free site to accept an electron. Some example of acceptor atoms include elements from Group II of the periodic chart such as for example, zinc, cadmium, beryllium, magnesium, calcium, etc. The acceptor atoms form recombination centers that accept or trap electrons and minimize leakage current to areas external to active region 29. Those skilled in the art will appreciate that the acceptor atoms typically are implanted through the portion of layer 23 that is within region 34. The acceptor atoms within the portion of layer 23 that is within region 34 function as acceptors as they would within layer 17 or 22.

In one example embodiment to form transistor 10 to have at least a one hundred volt (100V) differential breakdown voltage, region 34 was formed to have a width of approximately two (2) microns and preferably a width no less than between approximately one and two (1-2) microns. An embodiment may include region 34 having a width of up to one (1) millimeter. In one embodiment, the implanted atoms may have an effective concentration between approximately 1E13 and 1E16 atoms/cm². One embodiment may include implanting the atoms at a dose between approximately 1E11 and 1E16 atoms/cm² at an energy of 10-1000 KeV. Those skilled in the art will appreciate that the energy could be higher for other device designs.

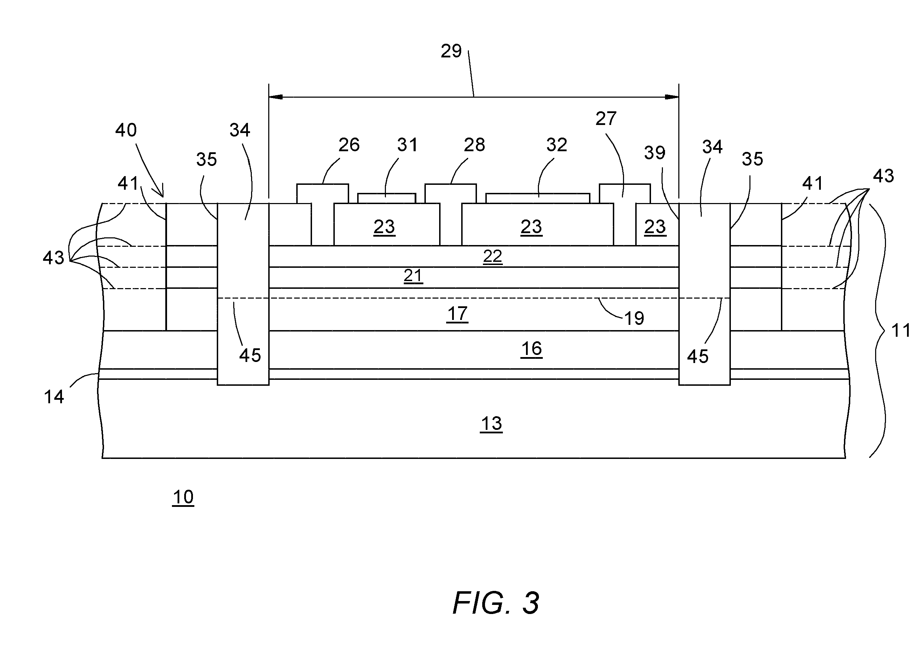

FIG. 3 illustrates an enlarged cross-sectional view of an example of a portion of an alternate embodiment of transistor 10. In other embodiments, isolation region 34 may extend further into the structure of transistor 10. For example, region 34 may extend through layer 17 and into layer 16 or may extend through layer 16 to at least touch or even extend a distance into substrate 13.

In some embodiments portions of layers 23, 22, 21, and 17 may be removed to form a mesa structure 40 extending away from substrate 13 and optionally layer 16. The removed material is illustrated in a general manner by dashed lines 43. An outside edge of mesa structure 40 is illustrated by an edge 41. In some embodiments there may portions of layers 23, 22, 21, and/or 17 abutting outside edge 41 and in other embodiments, there may not be portions of layers 23, 22, 21, and/or 17 abutting outside edge 41. In other embodiments, layers 23, 22, 21, and 17 are not removed and remain to extend to overly substrate 13 as illustrated by dashed lines 43.

As can be seen, in one embodiment a HEMT semiconductor device includes that the isolation region includes oxygen. For example, includes oxygen as a portion of an oxide some of the materials of transistor 10.

From all the foregoing, one skilled in the art will appreciate a that in one embodiment, a method of forming a HEMT semiconductor device may comprise: providing a substrate; forming a buffer layer overlying the substrate; forming a GaN layer overlying a surface of the substrate; forming an AlGaN layer overlying the GaN layer; and implanting oxygen atoms into portions of the AlGaN and GaN layers and into at least a portion of the buffer layer.

In another embodiment, the method may also include forming a dielectric layer overlying the AlGaN layer and implanting the oxygen atoms into the dielectric layer.

Another embodiment of the method may include implanting the oxygen atoms outside of source and drain regions of a HEMT transistor.

Those skilled in the art will also appreciate that in one embodiment of the present invention there is provided a HEMT semiconductor device comprising: a substrate having a surface; a GaN layer overlying the surface of the substrate; an AlGaN layer proximal to the GaN layer wherein a proximity of the GaN and AlGaN layers and a mole fraction of materials in the ALGaN layer are configured to form a 2DEG in the GaN layer; and an isolation region positioned along edges of the GaN and AlGaN layers, the isolation region extending from a surface of the AlGaN layer through the AlGaN layer, and into a first portion of the GaN layer wherein the isolation region is formed from one of forming oxygen atoms in the AlGaN and GaN layers, forming acceptor atoms in the AlGaN and GaN layers, or damaging atoms in the AlGaN and GaN layers.

An embodiment may include that the isolation region extends through the GaN layer into a buffer layer overlying the semiconductor substrate and underlying the GaN layer.

In another embodiment the HEMT semiconductor device may include at least a portion of source and drain regions of a HEMT transistor are internal to a structure formed by the isolation region.

Those skilled in the art will appreciate that an embodiment of a HEMT semiconductor device may comprise:
a semiconductor substrate having a surface; a GaN layer overlying the surface of the semiconductor substrate; an AlGaN layer proximal to the GaN layer wherein a proximity of the GaN and AlGaN layers and a mole fraction of materials in the AlGaN layer is configured to form a 2DEG in the GaN layer; a dielectric layer overlying the AlGaN layer; and an isolation region extending from a surface of the AlGaN layer through a first portion of the dielectric layer, through the AlGaN layer, and into a first portion of the GaN layer, the isolation region forming a multiply connected domain encircling second portions of the dielectric, GaN, and AlGaN layers wherein the isolation region is formed from one of forming oxygen atoms in the first portions of the AlGaN and GaN layers, forming acceptor atoms in the first portions of the AlGaN and GaN layers, or damaging atoms in the first portions of the AlGaN and GaN layers.

An embodiment may include that a portion of source and drain regions of a HEMT transistor may be within the multiply connected domain formed by the isolation region.

Another embodiment may include a buffer layer overlying the semiconductor substrate and underlying the GaN layer.

In an embodiment the isolation region may extend through the first portion of the GaN layer and into a first portion of the buffer layer.

An embodiment may include a third portion of the GaN and AlGaN layers extend laterally past the isolation region.

Those skilled in the art will appreciate that an embodiment of a method of forming a HEMT semiconductor device may comprise:
providing a substrate; forming a GaN layer overlying a surface of the substrate; forming an AlGaN layer proximal to the GaN layer and overlying the substrate wherein the AlGaN layer includes an Al mole fraction configured to form a 2DEG in the GaN layer; and forming an isolation region extending through a first portion of an interfacial region of the AlGaN layer and the GaN layer and at least to the 2DEG wherein the isolation region encircles a second portion of the AlGaN and GaN layers.

An embodiment of the method may include forming the AlGaN layer one of overlying or underlying the GaN layer.

Another embodiment of the method may include forming a buffer layer overlying the substrate and underlying the GaN layer and forming the isolation region extending through the GaN layer and one of to the buffer layer or into the buffer layer.

In an embodiment the method may include implanting oxygen atoms into the first portions of the AlGaN and GaN layers and forming an oxide of at least one of aluminum or gallium.

The method may include an embodiment that includes forming at least one dielectric layer overlying the AlGaN layer and implanting the oxygen atoms into portions of the dielectric layer.

An embodiment may include forming at least one dielectric layer including one of SiO_{X}, SiO_{X}N_{Y}, Si_{X}N_{Y}, Al_{X}O_{Y}, HfO_{X}, ZrO_{X}, YO_{X}.

In an embodiment, the method may include one of forming acceptor atoms in the isolation region or damaging atoms in the first portions of the AlGaN and GaN layers.

An embodiment of the method may include forming at least one dielectric layer overlying the AlGaN layer and further including one of forming acceptor atoms in a first portion of the at least one dielectric layer or damaging atoms in the first portion of the at least one dielectric layer wherein the dielectric layer is formed as a separate step from the step of forming the isolation region.

In an embodiment, the method may include implanting atoms of at least one element listed in Group II of a periodic chart of elements.

Another embodiment may include damaging atoms in the first portions of the AlGaN and GaN layers by implanting atoms of one of helium (He), hydrogen (H), iron (Fe), argon (Ar), nitrogen (N), carbon (C), or magnesium (Mg).

An embodiment may include implanting atoms of at least two of the elements selected from the list of helium (He), hydrogen (H), iron (Fe), argon (Ar), nitrogen (N), carbon (C), or magnesium (Mg).

Another embodiment may include forming the isolation region outside of drain region and at least a portion of a source region of a HEMT transistor.

Those skilled in the art will understand that an embodiment of a method of forming a HEMT semiconductor device may comprise: providing a substrate; forming a plurality of III-V or II-Vi compound semiconductor layers overlying the substrate wherein a material within at least a first semiconductor layer of the plurality of compound semiconductor layers is configured to form a 2DEG; and forming an isolation region extending through a first portion of the plurality of compound semiconductor layers and at least to the 2DEG.

Another embodiment of the method may include forming a dielectric layer overlying the plurality of compound semiconductor layers wherein the dielectric layer is formed in a separate step from the step that forms the isolation region.

An embodiment may include forming a GaN layer proximal to an AlGaN layer wherein a mole fraction of Al in the AlGaN layer is sufficient for forming the 2DEG.

In view of all of the above, it is evident that a novel device and method is disclosed.

While the subject matter of the descriptions are described with specific preferred embodiments and example embodiments, the foregoing drawings and descriptions thereof depict only typical and exemplary embodiments of the subject matter and are not therefore to be considered to be limiting of its scope, it is evident that many alternatives and variations will be apparent to those skilled in the art. For example, the descriptions use a transistor structure for explaining the subject matter, however, the methods and structures are applicable to other HEMT devices, for example a diode or MESHEMT. For clarity of the explanation, the preferred embodiment is explained, however, other embodiments are also possible.

As the claims hereinafter reflect, inventive aspects may lie in less than all features of a single foregoing disclosed embodiment. Thus, the hereinafter expressed claims are hereby expressly incorporated into this Detailed Description of the Drawings, with each claim standing on its own as a separate embodiment of an invention. Furthermore, while some embodiments described herein include some but not other features included in other embodiments, combinations of features of different embodiments are meant to be within the scope of the invention, and form different embodiments, as would be understood by those skilled in the art.

## Claims

1. A HEMT semiconductor device comprising:
a semiconductor substrate having a surface;
a GaN layer overlying the surface of the semiconductor substrate;
an AlGaN layer proximal to the GaN layer in which a proximity of the GaN and AlGaN layers and a mole fraction of materials in the AlGaN layer is configured to form a 2DEG in the GaN layer;
a dielectric layer overlying the AlGaN layer; and
an isolation region extending from a surface of the AlGaN layer through a first portion of the dielectric layer, through the AlGaN layer, and into a first portion of the GaN layer, the isolation region forming a multiply connected domain encircling second portions of the dielectric, GaN, and AlGaN layers in which the isolation region is formed from one of forming oxygen atoms in the first portions of the AlGaN and GaN layers, forming acceptor atoms in the first portions of the AlGaN and GaN layers, or damaging atoms in the first portions of the AlGaN and GaN layers.

2. The HEMT semiconductor device of claim 1 in which at least a portion of source and drain regions of a HEMT transistor are within the multiply connected domain formed by the isolation region.

3. The HEMT semiconductor device of claim 1 further including a buffer layer overlying the semiconductor substrate and underlying the GaN layer.

4. The HEMT semiconductor device of claim 3 in which the isolation region extends through the first portion of the GaN layer and into a first portion of the buffer layer.

5. A method of forming a HEMT semiconductor device comprises:
providing a substrate;
forming a plurality of III-V or II-VI compound semiconductor layers overlying the substrate in which a material within at least a first semiconductor layer of the plurality of compound semiconductor layers is configured to form a 2DEG; and
forming an isolation region extending through a first portion of the plurality of compound semiconductor layers and at least to the 2DEG.

6. The method of claim 5 further including forming a dielectric layer overlying the plurality of compound semiconductor layers wherein the dielectric layer is formed in a separate step from the step that forms the isolation region.

7. The method of claim 5 wherein forming the plurality of compound semiconductor layers includes forming a GaN layer proximal to an AlGaN layer wherein a mole fraction of Al in the AlGaN layer is sufficient for forming the 2DEG.

8. A method of forming a HEMT semiconductor device comprises:
providing a substrate;
forming a GaN layer overlying a surface of the substrate;
forming an AlGaN layer proximal to the GaN layer and overlying the substrate wherein the AlGaN layer includes an Al mole fraction configured to form a 2DEG in the GaN layer; and
forming an isolation region extending through a first portion of an interfacial region of the AlGaN layer and the GaN layer and at least to the 2DEG in which the isolation region encircles a second portion of the AlGaN and GaN layers.

9. The method of claim 8 in which forming the isolation region includes implanting oxygen atoms into the first portions of the AlGaN and GaN layers and forming an oxide of at least one of aluminum or gallium.

10. The method of claim 9 further including forming at least one dielectric layer overlying the AlGaN layer and implanting the oxygen atoms into portions of the dielectric layer.

11. The method of claim 8 in which forming the isolation region includes one of forming acceptor atoms in the isolation region or damaging atoms in the first portions of the AlGaN and GaN layers.

12. The method of claim 11 further including forming at least one dielectric layer overlying the AlGaN layer and further including one of forming acceptor atoms in a first portion of the at least one dielectric layer or damaging atoms in the first portion of the at least one dielectric layer wherein the dielectric layer is formed as a separate step from the step of forming the isolation region.

13. The method of claim 8 in which forming the acceptor atoms in the isolation region includes implanting atoms of at least one element listed in Group II of a periodic chart of elements.

14. The method of claim 11 wherein damaging atoms in the first portions of the AlGaN and GaN layers includes implanting atoms of one of helium (He), hydrogen (H), iron (Fe), argon (Ar), nitrogen (N), carbon (C), or magnesium (Mg).

15. The method of claim 11 in which damaging atoms in the first portions of the AlGaN and GaN layers includes implanting atoms of at least two of the elements selected from the list of helium (He), hydrogen (H), iron (Fe), argon (Ar), nitrogen (N), carbon (C), or magnesium (Mg).
